# EUROPEAN PATENT SPECIFICATION

(11) **EP 4 333 296 B1**
(45) Date of publication and mention of the grant of the patent: **25.12.2024**
(21) Application number: 23192070.3
(22) Date of filing: 18.08.2023
(51) Int. Cl.: H01L 29/20, H03F 3/195, H01L 29/417, H03F 3/213, H03F 3/217, H03F 3/24

(54) **DIGITAL RF AMPLIFIER**
DIGITALER HF-VERSTÄRKER
AMPLIFICATEUR RF NUMERIQUE

(30) Priority: 01.09.2022 NL 2032932
(43) Date of publication of application: 06.03.2024
(73) Proprietor: Ampleon Netherlands B.V., 6534 AV Nijmegen (NL)
(72) Inventor: DE BOET, Johannes Adrianus Maria, 6534 AV Nijmegen (NL); MAASSEN, Daniel, 6534 AV Nederland (NL); HEERES, Rob Mathijs, 6534 AV Nijmegen (NL)
(74) Representative: Arnold & Siedsma

(56) References cited:
- WO-A1-2021/162545
- US-A1- 2003 218 185

## Description

The present invention is related to a digital radiofrequency, RF, amplifier. The present invention is particularly related to a digital transmitter in which the digital RF amplifier is used. The digital RF amplifier can for example be used in high-speed and high-power applications, such as 5G mMIMO base stations.

Within the context of the present invention, a digital RF amplifier is an amplifier that receives a digital input signal and outputs an analog signal, more in particular an analog RF signal.

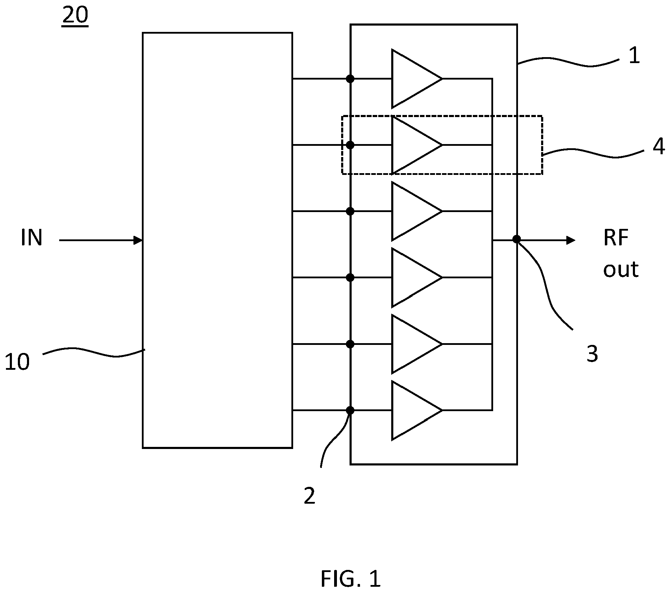

Digital RF amplifiers are known in the art. An example thereof is schematically shown in figure 1. In this figure, digital RF amplifier 20 comprises a driver 10 that receives a digital input signal IN. Driver 10 generates a plurality of control signals that are fed to respective transistor inputs 2 of a transistor 1 that is divided into a plurality of segments or cells 4. Each transistor input 2 is connected to a respective cell 4.

The control signals can either have an active level, in which the application of the control signal causes the connected transistor cell 4 to become saturated, or an inactive level, in which the application of the control signal causes connected transistor cell 4 to switch off and/or to not output any signal. The outputs of transistors cells 4 are combined into an RF output signal, RF out, emerging at transistor output 3.

In the example of figure 1, transistor 1 comprises six transistor inputs 2 for controlling six individual and identical transistor cells 4. Using this configuration, and assuming that each transistor cell 4 is either outputting its associated maximum output power or no output at all, a maximum total of 2^6 = 64 values are possible for the power of the analog RF signal outputted by transistor 1. Practical digital amplifiers may have many more transistor cells, e.g. 1024.

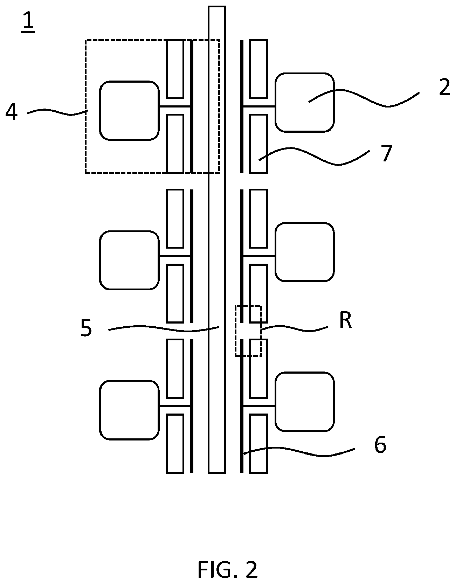

A detail of a known implementation of a transistor 1 for a digital amplifier, such as digital RF amplifier 20, is shown in figure 2. Here, part of a multi-finger transistor 1 is shown, wherein transistor 1 comprises a plurality of finger-shaped drain regions 5 (only one shown), a plurality of finger-shaped gate regions 6, and a plurality of source regions 7, wherein source regions 7 are generally connected to each other. Each combination of a drain region 5, gate region 6, and source region(s) 7 constitutes a transistor cell 4. More in particular, the drain region 5 of each transistor cell 4 forms an output terminal of that cell, the gate region 6 of each transistor cell 4 a control terminal, and the source region(s) 7 a common terminal.

As shown, source regions 7 are interrupted to allow a connection to be made between transistor inputs 2 of transistor 1 and gate regions 6. Furthermore, all drain regions 5 of transistor 1 are electrically connected to each other and to transistor output 3 (not shown).

In figure 2, each transistor input 2 is connected to a single gate region 6 of a single transistor cell 4. By driving transistor inputs 2, the various transistor cells 4 of transistor 1 can be activated thereby determining the power outputted by transistor 1.

To reduce Ohmic losses and/or resistance, gate regions 6 can be connected to finger-shaped metal structures. As gate regions 6 are relatively narrow, a via connection with an upper-lying metal layer of the finger-shaped metal structure is not possible. For that reason, the connection between the finger-shaped metal structures and the various gate regions 6 is typically realized in the regions where source regions 7 are interrupted. In these regions, relatively wide patches are formed that are connected to gate regions 6 and that allow a via connection with an upper-lying metal layer. The finger-shaped metal structures connected to gate regions 6, if used, are referred to as gate runners.

Drain regions 5 can also be connected to finger-shaped metal structures for reducing Ohmic losses and/or resistance. Typically, drain regions 5 are sufficiently wide to allow a via connection with an upper-lying metal layer.

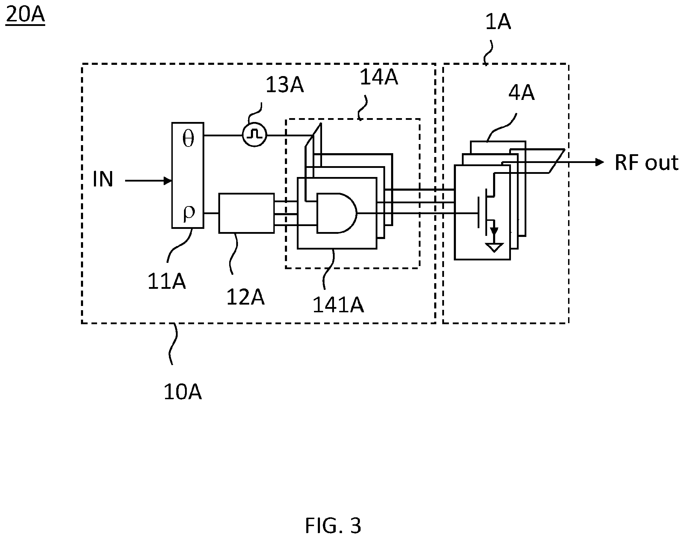

Figure 3 illustrates an implementation of a digital RF amplifier 20A based on polar modulation that is known from WO 2021162545 A1. Here, driver 10A of digital amplifier 20A comprises a first logic unit 11A that receives digital data IN and that generates digital magnitude ρ and phase θ values. The magnitude values are fed to a digital word generator 12A that generates a digital word based on the received magnitude value.

Clock generator 13A generates a clock signal, such as a pulse signal, having a constant frequency but with a phase offset that depends on the received phase value. The generated digital word and generated clock signal are fed to a second logic unit 14A that generates control signals to be fed to the transistor cells 4A of transistor 1A. Second logic unit 14A comprises a plurality of cells 141A, wherein each cell 141A generates a respective control signal for a respective transistor cell 4A in dependence of the clock signal and a respective bit of the generated digital word. For example, the control signal may have an active level when both the corresponding bit of the generated digital word and the clock signal have a logical high value, and an inactive level when either the corresponding bit of the generated digital word or the clock signal has a logical low value.

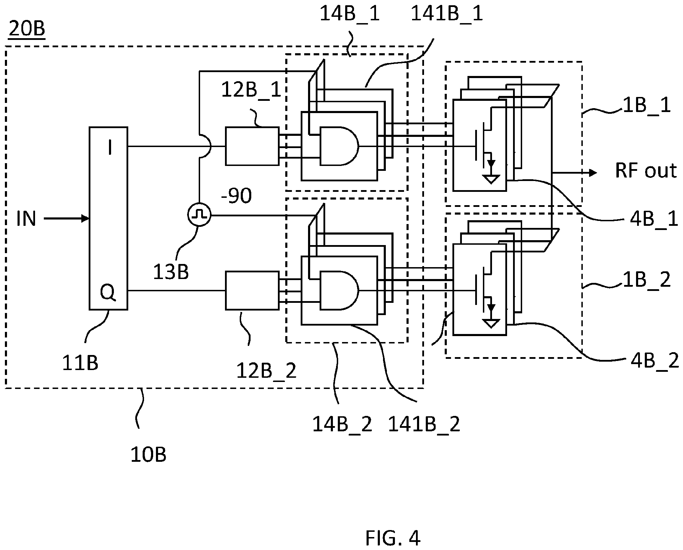

Figure 4 illustrates a known implementation of a digital amplifier 20B based on quadrature amplitude modulation. In this embodiment, first logic unit 11B generates digital in-phase signals I and quadrature signals Q based on digital input data IN. Clock generator 13B generates a clock signal, such as a pulse signal, having a constant frequency. The clock signal is fed to a primary second logic unit 14B_1. It is also fed to a secondary second logic unit 14B_2, albeit with a phase offset of -90 degrees relative to primary second logic unit 14B_1.

Primary digital word generator 12B_1 generates a first digital word based on the received I signal and secondary digital word generator 12B_2 generates a second digital word based on the received Q signal.

Primary and secondary second logic unit 14B_1, 14B_2 operate as second logic unit 14A of digital amplifier 20A shown in figure 3. The respective control signals are fed to respective transistor cells 4B_1, 4B_2 of transistors 1B_1, 1B_2, respectively, of which the analog output signals are combined. Each of the transistors 1B_1 and 1B_2 is similar to transistor 1A shown in figure 3 and transistor 1 shown in figure 2.

For proper control of the output power, and to achieve high gain and efficiency values for the digital amplifier, it is important that the transistor inputs can be driven separately. The Applicant has found that these objectives are difficult to achieve with the layout of the transistor shown in figure 2.

US 2003/218185A1 discloses a semiconductor device using an emitter top heterojunction bipolar transistor formed above a semiconductor substrate and having a planar shape in a ring-like shape. A structure is provided in which a base electrode is present only on an inner side of a ring-like emitter-base junction region.

An object of the present invention is to provide a digital RF amplifier in which the abovementioned problem is at least partially solved. This object is achieved with a digital RF amplifier as defined in claim 1 that is characterized in that the transistor is a circular transistor of which the control terminal and the output terminal of each transistor cell have a circular geometry and are concentrically arranged.

The Applicant has found that electromagnetic coupling between ends of adjacently arranged gate regions, as indicated in region R in figure 2, has a deteriorating effect on the isolation between the different transistor inputs. The Applicant further found that in topologies in which a drain region is shared among adjacent transistor cells, it is more difficult to individually control the behavior of the adjacent transistor cells. The Applicant has found that by using transistor cells having a circular geometry, coupling between different transistor inputs and/or different transistor cells can be mitigated, and performance of the digital RF amplifier can be improved.

The driver can be configured, when setting the signal level at a given output to the active level, to drive the at least one transistor cell corresponding to said given output into saturation. According to the invention, each output of the driver is connected to a respective transistor input. However, each transistor output can be connected to one or a plurality of transistor cells. Additionally or alternatively, all transistor cells are identical.

The control terminals of the plurality of transistor cells may have equal widths measured along a circumferential direction. Similarly, the control terminals of the plurality transistor cells may have equal lengths measured in a radial direction.

The driver can be configured to set a signal level at the outputs such that the number of outputs for which the signal level is set to the active level corresponds to a signal amplitude of the analog RF signal to be outputted. This is particularly useful when the total width of the control terminal associated with each transistor cell is identical. However, the total width of the control terminal for the transistor cells may be different. For example, by using a combination of relatively small and large transistor cells, an improvement in resolution can be obtained with respect to the signal amplitude. For example, in an embodiment wherein 5 transistor inputs are used that are each connected to a single transistor cell, and if 5 transistor cells are used that can output 1W, 2W, 2W, 5W, 10W, respectively, it becomes possible to generate an analog RF output signal having a power between 0W and 20W with increments of 1W. In an embodiment wherein 5 transistor cells are used that are each connected to a respective transistor input, and that can each output 4W, it becomes possible to generate an analog RF output signal having a power between 0W and 20W with increments of 4W. This improvement in resolution can also be used if the 5 transistor inputs are connected to respectively 1, 2, 2, 5, and 10 transistor cells that each have a saturated output power of 1W.

The digital amplifier may further comprise a conductive semiconductor substrate on which an epitaxial layer is arranged. The transistor can be integrated on and/or in the epitaxial layer, wherein the common terminals of all transistor cells are electrically connected to the conductive semiconductor substrate by means of one or more vias or highly doped regions extending between the common terminals and the conductive semiconductor substrate. Furthermore, the transistor cells may each form a Silicon-based laterally diffused metal oxide semiconductor, LDMOS, transistor. A width of the smallest control terminal among the transistor cells may then lie in a range between 10 and 100 micrometer, preferably between 10 and 50 micrometer.

Alternatively, the digital amplifier may comprise an isolating semiconductor substrate on which an epitaxial layer is arranged, wherein the transistor is integrated on and/or in the epitaxial layer. The transistor may further comprise a further transistor output electrically connected to the common terminals of the plurality of transistor cells. The transistor cells may each form a Gallium Nitride-based high electron mobility transistor. A width of the smallest control terminal among the transistor cells may then lie in a range between 10 and 100 micrometer, preferably between 10 and 50 micrometer.

For each transistor cell, the control terminal may surround the output terminal. For each such transistor cell the control terminal may comprise an island that extends radially away from a remainder of the control terminal through a passage between two regions of the common terminal of that transistor cell or over the common terminal of that transistor cell.

Alternatively, for each transistor cell the output terminal may surround the control terminal. A connection between each transistor input and a control terminal it is connected to may extend over the output terminal that corresponds to that control terminal and is separated from that output terminal by one or more dielectric layers.

In case the output terminal surrounds the control terminal and the abovementioned isolating semiconductor substrate is used, a connection between the further transistor output and a common terminal it is connected to may extend over the control terminal and the output terminal that corresponds to that common terminal and may be separated from the control terminal and the output terminal by one or more dielectric layers.

The driver may be flip-chipped onto the transistor. To this end, the transistor inputs of the transistor may each comprise a respective pad, and the outputs of the driver may each comprise a respective pad, wherein the pad of each transistor input is connected to the pad of a respective output of the driver, for example using a solder ball or other type of conductive connection. The solder balls may have a diameter ranging from 10 to 80 micrometer.

According to a second aspect of the present invention, a digital transmitter is provided that comprises an antenna and the digital RF amplifier described above, wherein the digital RF amplifier is configured to output the analog RF signal to the antenna.

Next, the present invention will be described in more detail referring to the appended drawings, wherein identical or similar components will be referred to using identical reference signs, and wherein:
Figure 1 is a schematic illustration of a known digital amplifier;
Figure 2 shows a known implementation of a transistor for the digital amplifier of figure 1;
Figure 3 illustrates an implementation of a known digital amplifier based on polar modulation;
Figure 4 illustrates a known implementation of a digital amplifier based on quadrature amplitude modulation;
Figure 5 illustrates a first and second example of a transistor cell used in a transistor in accordance with the present invention;
Figure 6 illustrates a detailed layout of a transistor corresponding to the first example of figure 5;
Figure 7 illustrates a detailed layout of a transistor corresponding to the second example of figure 5; and
Figure 8 illustrates an embodiment of a digital RF amplifier in accordance with the present invention.

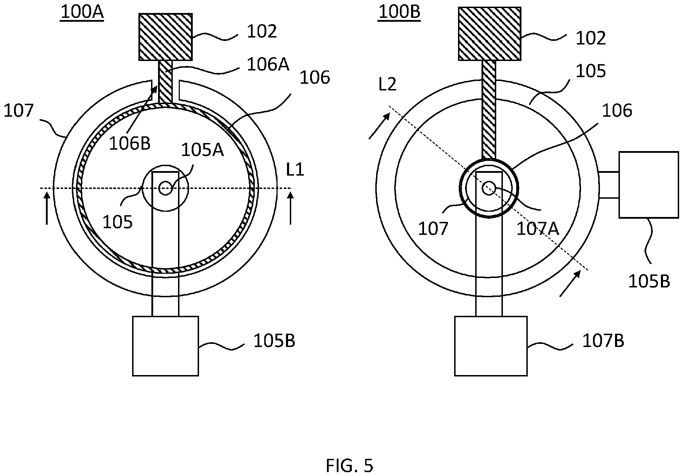

Figure 5, left, illustrates a first example of a transistor cell 100A that can be used in a transistor in accordance with the present invention.

Transistor cell 100A corresponds to an LDMOS transistor and comprises a gate pad 102 that connects to a ring-shaped gate region 106. In figure 5, left, gate pad 102 forms an input of the transistor. Alternatively, gate pads 102 of adjacently arranged transistor cells 100A are electrically connected to a single transistor input. The connection between gate pad 102 and gate region 106 comprises an island 106A that passes through a clearance or passage 106B in source region 107. Furthermore, gate region 106 surrounds a circular drain patch 105 that forms the drain region. Using a via 105A, patch 105 connects to a higher metal layer in which a drain pad 105B is realized. Drain pads 105B of the various transistor cells 100A of transistor 1 are electrically connected.

Ring-shaped gate region 106 is typically realized using a relatively thin conductive layer, such as a polysilicon layer, whereas gate pad 102 is realized using a relatively thick layer. To this end, transistor cell 100A is realized using a layer stack of conductive layers, wherein the upper layers are relatively thick. Connection between the different layers of the layer stack is possible using well-known vias.

As may be appreciated from the figure, gate regions 106 of neighboring transistor cells 100A are much less likely to couple electromagnetically when compared to the known transistor cell layout shown in figure 2. This can be attributed, at least partially, to the shielding of source region 107. Furthermore, a circular drain patch 105 of one transistor cell 100A is not involved in the electrical operation of another transistor cell 100A in the same manner as drain region 5 in figure 2.

In this example, it is assumed that the conductive substrate on which transistor cell 100A is realized is conductive. This allows a connection of source region 107 to ground through the substrate. In case the substrate is isolating, a via extending through the substrate could be used provided such technology is available for the semiconductor material system that is used for transistor cell 100A. For LDMOS transistors, the substrate typically comprises conductive Silicon substrates.

Typical dimensions of transistor cell 100A include an inner diameter of source region 107 in a range between 4 and 12 micrometer, an outer diameter of ring-shaped gate finger 106 in a range between 4 and 12 micrometer, and an outer diameter of circular drain patch 105 in a range between 1.5 and 4 micrometer. Typically, a source-gate separation lies in a range between 0.7 and 5, and a gate-drain separation in a range between 1 and 4 micrometer.

It is further noted that transistor cell 100A is realized on a Silicon semiconductor die having a conductive substrate and one or more epitaxial layers formed thereon. A cross section taken along line L1 corresponds to the cross section of known LDMOS transistors.

Figure 5, right, illustrates a second example of a transistor cell 100B that can be used in a transistor in accordance with the present invention. In this cell, ring-shaped gate region 106 surrounds a circular source patch 107, which patch 107 is connected through a via 107A to an upper-lying metal layer that connects to and/or is integrally formed with a source pad 107B. Ring-shaped drain region 105 surrounds ring-shaped gate region 106 and is connected to a drain pad 105B. Drain pads 105B of the various transistor cells 100B of transistor 1 are electrically connected. Similarly, source pads 107B of the various transistor cells 100B of transistor 1 are electrically connected.

In this embodiment, connection between source patch 107 and ground is realized through source pad 107B. This transistor cell 100B can therefore be used on isolating substrates.

Transistor cells 100B are typically spaced apart from each other in such a manner that drain regions 105 do not touch each other.

Similar to transistor cell 100A, the transistor action is localized within the circular geometry of the transistor cell 100B itself and does not interfere with the transistor action of an adjacent transistor cell 100B.

To prevent short-circuits between the various contacts in transistor cells 100A, 100B, dielectric crossovers or air-bridges may be used in a manner known in the art.

It is further noted that transistor cell 10BA is realized on a Gallium Nitride, GaN, die having a isolating substrate and one or more epitaxial layers formed thereon. A cross section taken along line L2 corresponds to the cross section of known GaN HEMTs.

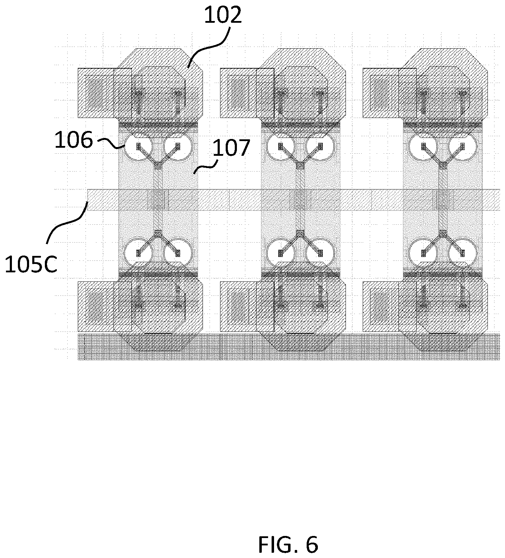

Figure 6 illustrates a detailed layout corresponding to transistor cell 100A of figure 5. As shown, each gate pad 102 forms a respective transistor input and is connected to the ring-shaped gate regions 106 of two transistor cells 100A. In addition, the circular drain patches 105 are connected to a drain runner 105C. Here, drain runner 105C comprises a track formed in a typically thick metal layer that is connected to the drain regions 105 of the transistor cells 100A. In figure 6, drain runner 105C is connected to 12 circular drain patches 105. Furthermore, source regions 107 of the different transistor cells 100A are connected together.

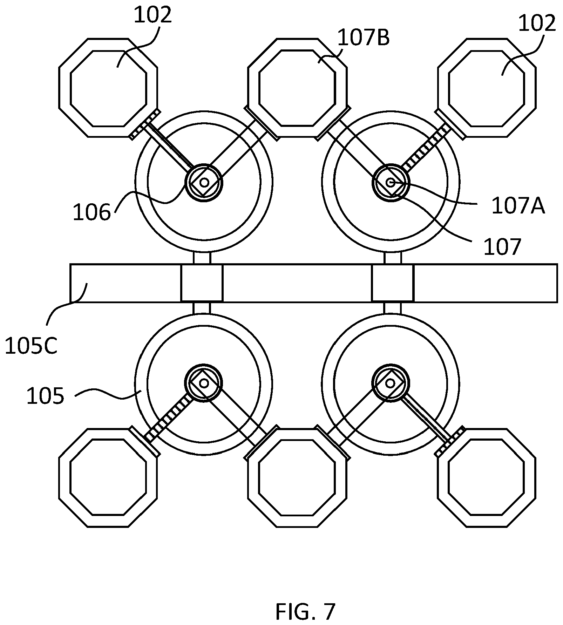

Figure 7 illustrates a detailed layout corresponding to transistor cell 100B of figure 5. As shown, each gate pad 102 forms a respective transistor input and is connected to the ring-shaped gate regions 106 of two transistor cells 100B (only one connection shown). In addition, the circular drain patches 105 are connected to a drain runner 105C. In figure 7, drain runner 105C is connected to 4 circular drain patches 105. Furthermore, source regions 107 of 2 different transistor cells 100B are connected together using source pad 107B.

A transistor in accordance with the present invention comprises a plurality of transistor cells, such as transistor cell 100A or transistor cell 100B. Such transistor can be used in the topology of figures 3 or 4. In such case, the driver, which is typically implemented in CMOS, can be flip-chipped onto the transistor. To this end, gate pads 102 may be connected to respective outputs of the driver using solder balls. Part of the transistor may correspond to the layout shown in figure 6 or 7.

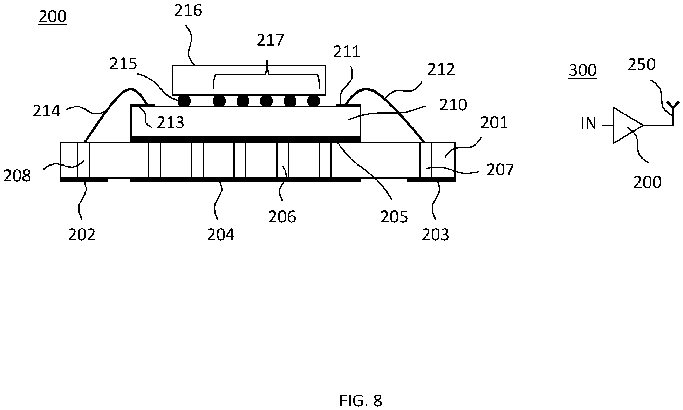

Figure 8 illustrates an embodiment of a digital RF amplifier 200 in accordance with the present invention. It comprises a printed circuit board 201 on which on the backside a land grid array, LGA, pattern is formed. This pattern comprises a first pad 202 for inputting a digital input signal, a second pad 203 for outputting an analog RF signal, and a central pad 204 for connecting to electrical ground. Central pad 204 is connected to a die pad 205 arranged on the opposing surface of PCB 201 using a plurality of vias 206.

A semiconductor die 210, in or on which the transistor in accordance with the present invention is integrated, is arranged on die pad 205. In figure 6, an LDMOS transistor is implemented. Furthermore, semiconductor die 210 comprises a conductive substrate allowing an electrical connection between the common terminals 107 of the transistor cells of the LDMOS transistor and die pad 205 without the use of via technology.

On the top surface of semiconductor die 210 a pad 211 is provided that is electrically connected to the transistor output and therefore to output terminals 105 of the various transistor cells of the LDMOS transistor. Pad 211 is connected, using a bondwire 212, to a pad (not shown) on PCB 201. This latter pad is connected to pad 203 through a via 207.

On the top surface of semiconductor die 210 a pad 213 is provided that is electrically connected, through a bondwire 214, to a pad (not shown) on PCB 201. This latter pad is connected to pad 202 through a via 208.

Pad 213 is electrically connected to a solder ball 215 that makes a connection to the input of the driver 10 that is integrated on and/or in semiconductor die 216, which is flip-chipped onto semiconductor die 210. The outputs of driver 10 are connected, using solder balls 217, to the transistor inputs of the LDMOS transistor realized on semiconductor die 210.

It should be noted that other connections, such as a connection for providing a supply voltage, are not shown in figure 8. Furthermore, figure 8 illustrates but one possible implementation of a digital RF amplifier in accordance with the present invention. For example, lead-frame bases solutions are equally possible.

Further 8 further illustrates an embodiment of a digital transmitter 300 in accordance with the present invention. It comprises an antenna 250 and the digital RF amplifier according to the present invention, for example digital RF amplifier 200. Here, digital RF amplifier 200 receives a digital input signal, IN, and outputs an analog RF signal to antenna 250.

In the above, the present invention was explained using detailed embodiments thereof. However, the present invention is not limited to these embodiments. Various modifications are possible without deviating from the scope of the present invention, which is defined by the appended claims.

## Claims

1. A digital radiofrequency, RF, amplifier (200), comprising:
a driver (10) having a plurality of outputs and being configured to individually set a signal level at the outputs either to an inactive level or to an active level in response to a digital input signal (IN);
a transistor (1) configured to output an analog RF signal (RF OUT) at a transistor output (3), the transistor comprising:
a plurality of transistor cells (100A; 100B), each transistor cell (100A; 100B) comprising a control terminal (106), such as a gate or base, an output terminal (105), such as a drain or collector, and a common terminal (107), such as a source or emitter;
a plurality of transistor inputs (102), each transistor input (102) being electrically connected to the control terminal (106) of at least one transistor cell (100A; 100B), wherein the transistor inputs (102) are mutually electrically isolated, and wherein each transistor input (102) is connected to a different output of the driver (10);
wherein the transistor output (3) is electrically connected to the output terminals (105) of the plurality of transistor cells (100A; 100B);
**characterized in that** the transistor (1) is a circular transistor of which the control terminal (106) and the output terminal (105) of each transistor cell (100A; 100B) have a circular geometry and are concentrically arranged.

2. The digital amplifier (200) according to claim 1, wherein the driver (10) is configured, when setting the signal level at a given output to the active level, to drive the at least one transistor cell (100A; 100B) corresponding to said given output into saturation.

3. The digital amplifier (200) according to any of the previous claims, wherein a momentary value of the digital input signal (IN) is representative for the momentary amplitude of the analog RF signal (RF OUT) to be outputted.

4. The digital amplifier (200) according to any of the previous claims, wherein the control terminals (106) of the plurality of transistor cells (100A; 100B) have equal widths measured along a circumferential direction.

5. The digital amplifier (200) according to claim 4, wherein the driver (10) is configured to set a signal level at the outputs such that the number of outputs for which the signal level is set to the active level corresponds to a signal amplitude of the analog RF signal to be outputted.

6. The digital amplifier (200) according to any of the previous claims, comprising a conductive semiconductor substrate on which an epitaxial layer is arranged, wherein the transistor (1) is integrated on and/or in the epitaxial layer, wherein the common terminals (107) of all transistor cells (100A; 100B) are electrically connected to the conductive semiconductor substrate by means of one or more vias or highly doped regions extending between the common terminals (107) and the conductive semiconductor substrate.

7. The digital amplifier (200) according to claim 6, wherein the transistor cells (100A; 100B) each form a Silicon-based laterally diffused metal oxide semiconductor, LDMOS, transistor.

8. The digital amplifier (200) according to claim 7, wherein a width of the smallest control terminal (106) among the transistor cells (100A; 100B) lies in a range between 10 and 100 micrometer.

9. The digital amplifier (200) according to any of the claims 1-5, comprising an isolating semiconductor substrate on which an epitaxial layer is arranged, wherein the transistor (1) is integrated on and/or in the epitaxial layer, the transistor (1) further comprising a further transistor output electrically connected to the common terminals (107) of the plurality of transistor cells (100B).

10. The digital amplifier (200) according to claim 9, wherein the transistor cells (100B) each form a Gallium Nitride-based high electron mobility transistor, wherein a width of the smallest control terminal (106) among the transistor cells (100B) preferably lies in a range between 10 and 100 micrometer.

11. The digital amplifier (200) according to any of the previous claims, wherein for each transistor cell (100A) the control terminal (106) surrounds the output terminal (105), wherein for each transistor cell (100A) the control terminal (106) preferably comprises an island (106A) that extends radially away from a remainder of the control terminal (106) through a passage (106B) between two regions of the common terminal (107) of that transistor cell (100A) or over the common terminal (107) of that transistor cell (100A).

12. The digital amplifier (200) according to any of the claims 1-10, wherein for each transistor cell (100B) the output terminal (105) surrounds the control terminal (106);
wherein a connection (102A) between each transistor input (102) and a control terminal (106) it is connected to preferably extends over the output terminal (105) that corresponds to that control terminal (102) and is separated from that output terminal (105) by one or more dielectric layers.

13. The digital amplifier (200) according to claim 12 and claim 9, wherein a connection (107C) between the further transistor output and a common terminal (107) it is connected to extends over the control terminal (106) and the output terminal (105) that correspond to that common terminal (107) and is separated from the control terminal (106) and output terminal (105) by one or more dielectric layers.

14. The digital amplifier (200) according to any of the previous claims, wherein the driver (10) is flip-chipped onto the transistor (1), wherein, preferably:
the transistor inputs (102) of the transistor (1) each comprise a respective pad, and wherein the outputs of the driver (10) each comprise a respective pad, wherein the pad of each transistor input (102) is connected to the pad of a respective output of the driver, for example using a solder ball or other conductive connection.

15. A digital transmitter (300), comprising:
an antenna (250);
the digital RF amplifier (200) according to any of the previous claims, wherein the digital RF amplifier (200) is configured to output the analog RF signal to the antenna.

## Patentansprüche

1. Digitaler Hochfrequenzverstärker, HF-Verstärker, (200), umfassend:
einen Treiber (10), der eine Vielzahl von Ausgängen aufweist und konfiguriert ist, um einen Signalpegel an den Ausgängen, entweder auf einen inaktiven Pegel oder auf einen aktiven Pegel als Reaktion auf ein digitales Eingangssignal (IN), einzustellen;
einen Transistor (1), der konfiguriert ist, um ein analoges HF-Signal (RF OUT) an einem Transistorausgang (3) auszugeben, der Transistor umfassend:
eine Vielzahl von Transistorzellen (100A; 100B), jede Transistorzelle (100A; 100B) umfassend einen Steueranschluss (106), wie ein Gate oder eine Basis, einen Ausgangsanschluss (105), wie einen Drain oder einen Kollektor und einen gemeinsamen Anschluss (107), wie eine Source oder einen Emitter;
eine Vielzahl von Transistoreingängen (102), wobei jeder Transistoreingang (102) mit dem Steueranschluss (106) von mindestens einer Transistorzelle (100A; 100B) elektrisch verbunden ist, wobei die Transistoreingänge (102) gegenseitig elektrisch isoliert sind, und wobei jeder Transistoreingang (102) mit einem unterschiedlichen Ausgang des Treibers (10) verbunden ist;
wobei der Transistorausgang (3) mit den Ausgangsanschlüssen (105) der Vielzahl von Transistorzellen (100A; 100B) elektrisch verbunden ist;
**dadurch gekennzeichnet, dass** der Transistor (1) ein kreisförmiger Transistor ist, bei dem der Steueranschluss (106) und der Ausgangsanschluss (105) jeder Transistorzelle (100A; 100B) eine kreisförmige Geometrie aufweisen und konzentrisch angeordnet sind.

2. Digitaler Verstärker (200) nach Anspruch 1, wobei der Treiber (10) konfiguriert ist, um, wenn der Signalpegel an einem gegebenen Ausgang auf den aktiven Pegel eingestellt wird, die mindestens eine Transistorzelle (100A; 100B), die dem gegebenen Ausgang entspricht, in die Sättigung zu treiben.

3. Digitaler Verstärker (200) nach einem der vorstehenden Ansprüche, wobei ein momentaner Wert des digitalen Eingangssignals (IN) die momentane Amplitude des auszugebenden analogen HF-Signals (RF OUT) darstellt.

4. Digitaler Verstärker (200) nach einem der vorstehenden Ansprüche, wobei die Steueranschlüsse (106) der Vielzahl von Transistorzellen (100A; 100B) gleiche Breiten, gemessen entlang einer Umfangsrichtung, aufweisen.

5. Digitaler Verstärker (200) nach Anspruch 4, wobei der Treiber (10) konfiguriert ist, um einen Signalpegel an den Ausgängen derart einzustellen, dass die Anzahl der Ausgänge, für die der Signalpegel auf den aktiven Pegel eingestellt wird, einer Signalamplitude des auszugebenden analogen HF-Signals entspricht.

6. Digitaler Verstärker (200) nach einem der vorstehenden Ansprüche, umfassend ein leitfähiges Halbleitersubstrat, auf dem eine epitaktische Schicht angeordnet ist, wobei der Transistor (1) auf und/oder in der epitaktischen Schicht integriert ist, wobei die gemeinsamen Anschlüsse (107) aller Transistorzellen (100A; 100B) mit dem leitfähigen Halbleitersubstrat mittels einer oder mehrerer Durchkontaktierungen oder hochdotierter Regionen, die sich zwischen den gemeinsamen Anschlüssen (107) und dem leitfähigen Halbleitersubstrat erstrecken, elektrisch verbunden sind.

7. Digitaler Verstärker (200) nach Anspruch 6, wobei die Transistorzellen (100A; 100B) jeweils einen lateral diffundierten Metalloxid-Halbleiter-Transistor auf Siliziumbasis, LDMOS-Transistor, ausbilden.

8. Digitaler Verstärker (200) nach Anspruch 7, wobei eine Breite des kleinsten Steueranschlusses (106) unter den Transistorzellen (100A; 100B) in einem Bereich zwischen 10 und 100 Mikrometer liegt.

9. Digitaler Verstärker (200) nach einem der Ansprüche 1 bis 5, umfassend ein isolierendes Halbleitersubstrat, auf dem eine epitaktische Schicht angeordnet ist, wobei der Transistor (1) auf und/oder in der epitaktischen Schicht integriert ist, der Transistor (1) ferner umfassend einen weiteren Transistorausgang, der mit den gemeinsamen Anschlüssen (107) der Vielzahl von Transistorzellen (100B) elektrisch verbunden ist.

10. Digitaler Verstärker (200) nach Anspruch 9, wobei die Transistorzellen (100B) jeweils einen Transistor mit hoher Elektronenbeweglichkeit auf Galliumnitridbasis ausbilden, wobei eine Breite des kleinsten Steueranschlusses (106) unter den Transistorzellen (100B) vorzugsweise in einem Bereich zwischen 10 und 100 Mikrometer liegt.

11. Digitaler Verstärker (200) nach einem der vorstehenden Ansprüche, wobei für jede Transistorzelle (100A) der Steueranschluss (106) den Ausgangsanschluss (105) umgibt, wobei für jede Transistorzelle (100A) der Steueranschluss (106) vorzugsweise eine Insel (106A) umfasst, die sich radial weg von einem Rest des Steueranschlusses (106) durch einen Durchgang (106B) zwischen zwei Regionen des gemeinsamen Anschlusses (107) dieser Transistorzelle (100A) oder über den gemeinsamen Anschluss (107) dieser Transistorzelle (100A) erstreckt.

12. Digitaler Verstärker (200) nach einem der Ansprüche 1 bis 10, wobei für jede Transistorzelle (100B) der Ausgangsanschluss (105) den Steueranschluss (106) umgibt;
wobei eine Verbindung (102A) zwischen jedem Transistoreingang (102) und einem Steueranschluss (106), mit dem er verbunden ist, sich vorzugsweise über den Ausgangsanschluss (105) erstreckt, der diesem Steueranschluss (102) entspricht, und von diesem Ausgangsanschluss (105) durch eine oder mehrere dielektrische Schichten getrennt ist.

13. Digitaler Verstärker (200) gemäß Anspruch 12 und Anspruch 9, wobei sich eine Verbindung (107C) zwischen dem weiteren Transistorausgang und einem gemeinsamen Anschluss (107), mit dem er verbunden ist, über den Steueranschluss (106) und den Ausgangsanschluss (105) erstreckt, die diesem gemeinsamen Anschluss (107) entsprechen, und von dem Steueranschluss (106) und dem Ausgangsanschluss (105) durch eine oder mehrere dielektrische Schichten getrennt ist.

14. Digitaler Verstärker (200) nach einem der vorstehenden Ansprüche, wobei der Treiber (10) per Flip-Chip auf den Transistor (1) aufgesetzt ist, wobei vorzugsweise:
die Transistoreingänge (102) des Transistors (1) jeweils ein entsprechendes Pad umfassen, und wobei die Ausgänge des Treibers (10) jeweils ein entsprechendes Pad umfassen, wobei das Pad jedes Transistoreingangs (102) mit dem Pad eines entsprechenden Ausgangs des Treibers verbunden ist, beispielsweise unter Verwendung einer Lötkugel oder einer anderen leitfähigen Verbindung.

15. Digitaler Sender (300), umfassend:
eine Antenne (250);
den digitalen HF-Verstärker (200) nach einem der vorstehenden Ansprüche, wobei der digitale HF-Verstärker (200) konfiguriert ist, um das analoge HF-Signal an die Antenne auszugeben.

## Revendications

1. Amplificateur radiofréquence, RF, numérique (200) comprenant :
un circuit d'attaque (10) comportant plusieurs sorties et configuré pour régler individuellement un niveau de signal sur les sorties soit à un niveau inactif, soit à un niveau actif en réponse à un signal d'entrée numérique (IN) ;
un transistor (1) configuré pour émettre en sortie un signal RF analogique (RF OUT) sur une sortie de transistor (3), le transistor comprenant :
une pluralité de cellules de transistor (100A ; 100B), chaque cellule de transistor (100A ; 100B) comprenant une borne de commande (106), telle qu'une grille ou une base, une borne de sortie (105), telle qu'un drain ou un collecteur, et une borne commune (107), telle qu'une source ou un émetteur ;
une pluralité d'entrées de transistor (102), chaque entrée de transistor (102) étant connectée électriquement à la borne de commande (106) d'au moins une cellule de transistor (100A ; 100B), dans lequel les entrées de transistor (102) sont isolées électriquement les unes des autres, et dans lequel chaque entrée de transistor (102) est connectée à une sortie différente du circuit d'attaque (10) ;
dans lequel la sortie de transistor (3) est connectée électriquement aux bornes de sortie (105) de la pluralité de cellules de transistor (100A ; 100B) ;
**caractérisé en ce que** le transistor (1) est un transistor circulaire dont la borne de commande (106) et la borne de sortie (105) de chaque cellule de transistor (100A ; 100B) ont une géométrie circulaire et sont disposées de manière concentrique.

2. Amplificateur numérique (200) selon la revendication 1, dans lequel le circuit d'attaque (10) est configuré, lors du réglage du niveau de signal sur une sortie donnée au niveau actif, pour amener à saturation au moins une cellule de transistor (100A) ; 100B) correspondant à ladite sortie donnée.

3. Amplificateur numérique (200) selon l'une quelconque des revendications précédentes, dans lequel une valeur momentanée du signal d'entrée numérique (IN) est représentative de l'amplitude momentanée du signal RF analogique (RF OUT) à émettre en sortie.

4. Amplificateur numérique (200) selon l'une quelconque des revendications précédentes, dans lequel les bornes de commande (106) de la pluralité de cellules de transistor (100A ; 100B) ont des largeurs égales mesurées le long d'une direction circonférentielle.

5. Amplificateur numérique (200) selon la revendication 4, dans lequel le circuit d'attaque (10) est configuré pour régler un niveau de signal sur les sorties de telle sorte que le nombre de sorties pour lesquelles le niveau de signal est réglé sur le niveau actif correspond à une amplitude de signal du signal RF analogique à émettre en sortie.

6. Amplificateur numérique (200) selon l'une quelconque des revendications précédentes, comprenant un substrat semi-conducteur conducteur sur lequel est disposée une couche épitaxiale, dans lequel le transistor (1) est intégré sur et/ou dans la couche épitaxiale, dans lequel les bornes communes (107) de toutes les cellules de transistor (100A ; 100B) sont connectées électriquement au substrat semi-conducteur conducteur au moyen d'un ou plusieurs trous d'interconnexion ou de régions fortement dopées s'étendant entre les bornes communes (107) et le substrat semi-conducteur conducteur.

7. Amplificateur numérique (200) selon la revendication 6, dans lequel les cellules de transistor (100A ; 100B) forment chacune un transistor LDMOS (semi-conducteur à oxyde métallique à diffusion latérale) à base de silicium.

8. Amplificateur numérique (200) selon la revendication 7, dans lequel une largeur de la plus petite borne de commande (106) parmi les cellules de transistor (100A ; 100B) varie dans une plage entre 10 et 100 micromètres.

9. Amplificateur numérique (200) selon l'une quelconque des revendications 1 à 5, comprenant un substrat semi-conducteur isolant sur lequel est disposée une couche épitaxiale, dans lequel le transistor (1) est intégré sur et/ou dans la couche épitaxiale, le transistor (1) comprenant en outre une autre sortie de transistor connectée électriquement aux bornes communes (107) de la pluralité de cellules de transistor (100B).

10. Amplificateur numérique (200) selon la revendication 9, dans lequel les cellules de transistor (100B) forment chacune un transistor à haute mobilité électronique à base de nitrure de gallium, dans lequel une largeur de la plus petite borne de commande (106) parmi les cellules de transistor (100B) varie de préférence dans une plage entre 10 et 100 micromètres.

11. Amplificateur numérique (200) selon l'une quelconque des revendications précédentes, dans lequel pour chaque cellule de transistor (100A) la borne de commande (106) entoure la borne de sortie (105), dans lequel pour chaque cellule de transistor (100A) la borne de commande (106) comprend de préférence un îlot (106A) qui s'étend radialement à l'opposé d'un reste de la borne de commande (106) à travers un passage (106B) entre deux régions de la borne commune (107) de cette cellule de transistor (100A) ou au-dessus de la borne commune (107) de cette cellule de transistor (100A).

12. Amplificateur numérique (200) selon l'une quelconque des revendications 1 à 10, dans lequel, pour chaque cellule de transistor (100B), la borne de sortie (105) entoure la borne de commande (106) ;
dans lequel une connexion (102A) entre chaque entrée de transistor (102) et une borne de commande (106) à laquelle elle est connectée s'étend de préférence au-dessus de la borne de sortie (105) qui correspond à cette borne de commande (102) et est séparée de cette borne de sortie (105) par une ou plusieurs couches diélectriques.

13. Amplificateur numérique (200) selon la revendication 12 et la revendication 9, dans lequel une connexion (107C) entre la sortie de transistor supplémentaire et une borne commune (107) à laquelle elle est connectée s'étend au-dessus de la borne de commande (106) et de la borne de sortie (105) qui correspondent à cette borne commune (107) et est séparée de la borne de commande (106) et de la borne de sortie (105) par une ou plusieurs couches diélectriques.

14. Amplificateur numérique (200) selon l'une quelconque des revendications précédentes, dans lequel le circuit d'attaque (10) est monté en puce retournée sur le transistor (1), dans lequel, de préférence :
les entrées de transistor (102) du transistor (1) comprennent chacune une pastille respective, et les sorties du circuit d'attaque (10) comprennent chacune une pastille respective, dans lequel la pastille de chaque entrée de transistor (102) est connectée à la pastille d'une sortie respective du circuit d'attaque, par exemple à l'aide d'une bille de soudure ou d'une autre connexion conductrice.

15. Émetteur numérique (300), comprenant :
une antenne (250) ;
l'amplificateur RF numérique (200) selon l'une quelconque des revendications précédentes, dans lequel l'amplificateur RF numérique (200) est configuré pour émettre en sortie le signal RF analogique vers l'antenne.
